# EUROPÄISCHE PATENTSCHRIFT

(11) **EP 1 371 271 B1**
(45) Veröffentlichungstag und Bekanntmachung des Hinweises auf die Patenterteilung: **24.02.2010**
(21) Anmeldenummer: 01989368.4
(22) Anmeldetag: 05.12.2001
(51) Int. Cl.: H05H 1/30, H01J 37/32

(54) **PLASMAANLAGE UND VERFAHREN ZUR ERZEUGUNG EINER FUNKTIONSBESCHICHTUNG**
PLASMA INSTALLATION AND METHOD FOR PRODUCING A FUNCTIONAL COATING
INSTALLATION DE PLASMA ET PROCEDE DE PRODUCTION D'UN REVETEMENT FONCTIONNEL

(30) Priorität: 02.02.2001 DE 10104613
(43) Veröffentlichungstag der Anmeldung: 17.12.2003
(73) Patentinhaber: ROBERT BOSCH GMBH, 70442 Stuttgart (DE)
(72) Erfinder: GROSSE, Stefan, 70839 Gerlingen (DE); HENKE, Sascha, 71263 Weil Der Stadt (DE); SPINDLER, Susanne, 70197 Stuttgart (DE)
(86) Internationale Anmeldenummer: PCT/DE2001/004565
(87) Internationale Veröffentlichungsnummer: WO 2002/062115

(56) Entgegenhaltungen:
- DE-A- 19 603 323
- DE-A- 19 911 046
- US-A- 5 241 245
- US-A- 5 355 832
- US-A- 6 130 397
- US-A- 6 136 139
- PATENT ABSTRACTS OF JAPAN vol. 1995, no. 10, 30. November 1995 (1995-11-30) & JP 07 169758 A (TOSHIBA CORP), 4. Juli 1995 (1995-07-04)

## Beschreibung

Die Erfindung betrifft eine Plasmaanlage mit einer induktiv gekoppelten Hochfrequenz-Plasmastrahlquelle und ein Verfahren zur Erzeugung einer Funktionsbeschichtung auf einem Substrat nach der Gattung der unabhängigen Ansprüche.

### Stand der Technik

Das Aufbringen von Funktionsschichten auf Substrate ist ein weit verbreitetes Verfahren, um Oberflächen von Werkstücken bzw. Bauteilen gewünschte Eigenschaften zu geben. Ein übliches Verfahren, um derartige Funktionsschichten zu erzeugen, ist das Plasmabeschichten im Feinvakuum oder Hochvakuum, was aufwendige Evakuierungstechniken erfordert und zudem nur relativ geringe Beschichtungsraten liefert. Daher ist dieses Verfahren zeitintensiv und teuer.

Zur Beschichtung von Substraten im subatmosphärischen und atmosphärischen Druckbereich eignen sich insbesondere thermische Plasmen, mit denen hohe Beschichtungsraten im Bereich von mm/h erreichbar sind. Dazu sei beispielsweise auf R. Henne, Contribution to Plasma Physics, 39 (1999), Seiten 385 - 397, verwiesen. Besonders vielversprechend unter den thermischen Plasmaquellen ist die induktiv gekoppelte Hochfrequenz-Plasmastrahlquelle (HF-ICP-Strahlquelle), wie sie aus E. Pfender und C. H. Chang "Plasma Spray Jets and Plasma Particulate Interaction: Modelling and Experiments", Tagungsband des 6. Workshop Plasmatechnik, TU Illmenau, 1998, bekannt ist. Zudem ist in der Anmeldung DE 199 58 474.5 auch bereits ein Verfahren zur Erzeugung von Funktionsschichten mit einer derartigen Plasmastrahlquelle vorgeschlagen worden.

Die Vorteile der HF-ICP-Strahlquelle liegen einerseits im Bereich der Arbeitsdrücke in der Quelle, die üblicherweise von 50 mbar bis hin zu 1 bar und mehr reichen, und andererseits in der großen Vielfalt der einsetzbaren und mit einer derartigen Plasmastrahlquelle abscheidbaren Materialien. Insbesondere sind dadurch, dass die Ausgangsstoffe axial in den sehr heißen Plasmastrahl eingebracht werden, auch Hartstoffe mit sehr hohen Schmelztemperaturen verwendbar. Ein weiterer Vorteil der HF-ICP-Strahlquelle liegt darin, dass diese ohne Elektroden arbeitet, d.h. es sind Verunreinigungen der zu erzeugenden Schichten durch das Elektrodenmaterial aus der Strahlquelle ausgeschlossen.

Nachteilig bei bekannten HF-ICP-Strahlquellen und Plasmaanlagen mit derartigen Plasmastrahlquellen sind die hohen Temperaturen im Plasmastrahl von einigen 1000°C, denen weitgehend auch das zu beschichtende Substrat ausgesetzt ist. Insofern ist die Auswahl einsetzbarer Substrate deutlich eingeschränkt. Weiter ist nachteilig, dass zur Herstellung von Schichtsystemen auf dem Substrat, wie sie derzeit beispielsweise über CVD-Verfahren hergestellt werden, vielfach eine Mindestenergie der auf das Substrat auftreffenden Teilchen erforderlich ist. Dies gilt insbesondere bei der Abscheidung von DLC-Beschichtungen ("diamond-like carbon"). Diese Mindestenergie der auftreffenden Ionen wird bei den bisher bekannten induktiv gekoppelten Hochfrequenz-Plasmastrahlquellen und den damit versehenen Plasmaanlagen nicht erreicht.

Aufgabe der vorliegenden Erfindung war die Bereitstellung einer Plasmaanlage mit einer induktiv gekoppelten Hochfrequenz-Plasmastrahlquelle und eines Verfahrens zur Erzeugung von Funktionsbeschichtungen, zu deren Abscheidung eine höhere Energie der aus dem Plasma auftreffenden Ionen erforderlich ist, als sie bei üblichen HF-ICP-Plasmastrahlquellen gegeben ist. Insbesondere war es Aufgabe der vorliegenden Erfindung, eine Plasmaanlage und ein Verfahren bereitzustellen, mit dem die Herstellung von harten Kohlenstoff-Beschichtungen, d.h. DLC-Schichten, im Grobvakuum möglich ist.

In der Schrift US-A-6,136,139 wird eine Plasmaanlage beschrieben, bei der mit einer induktiv gekoppelten Hochfrequenzplasmastrahlquelle und mit einem einen Plasmaerzeugungsraum begrenzenden Brennerkörper mit einer Austrittsöffnung für den Plasmastrahl gearbeitet wird. Dabei ist aber kein Plasmastrahl im eigentlichen Sinne vorhanden, sondern es wird mit einem diffundierenden Plasma gearbeitet, das in einer Zuführeinrichtung geführt wird. In dieser Schrift werden aber keine Hinweise auf eine zweite Zuführeinrichtung oder auf eine zeitlich veränderbare elektrische Spannung gegeben.

### Vorteile der Erfindung

Die erfindungsgemäße Plasmaanlage mit einer induktiv gekoppelten Hochfrequenz-Plasmastrahlquelle und das erfindungsgemäße Verfahren zur Erzeugung einer Funktionsbeschichtung auf einem Substrat hat gegenüber dem Stand der Technik den Vorteil, dass damit Schichten bzw. Schichtsysteme erzeugbar sind, die bisher lediglich über CVD-Verfahren abgeschieden werden konnten.

Dadurch, dass der bei der Abscheidung von Schichten mit HF-ICP-Plasmastrahlquellen herrschende Druck in der Kammer von üblicherweise 100 mbar bis 1 bar auf weniger als 50 mbar abgesenkt wird, wird vorteilhaft erreicht, dass den in dem Plasma vorliegenden Ionen eine ausreichende mittlere freie Weglänge zur Verfügung steht, und damit die elektrische Spannung, mit der die Substratelektrode und darüber das mit der Substratelektrode in Verbindung stehende Substrat beaufschlagt wird, auch eine ausreichende Wirkung hinsichtlich der gewünschten Beschleunigung entfaltet. Daneben senkt dieser Druck die Temperaturbelastung des bearbeiteten Substrates deutlich.

Andererseits ist vorteilhaft, dass die erfindungsgemäße Plasmaanlage auch in der Kammer, in der sich das Substrat befindet, lediglich ein Grobvakuum von weniger als 50 mbar erfordert, um die für die gewünschten Beschichtungsprozesse bzw. Oberflächenmodifikationen ausreichende Ionenenergien zu gewährleisten. Die Erzeugung eines Grobvakuums in der Kammer der Plasmaanlage ist dabei mit üblichen Pumpeinrichtungen zuverlässig und schnell erreichbar, und erfordert gegenüber einem Feinvakuum oder einem Hochvakuum, wie dies bei CVD-Verfahren erforderlich ist, einen deutlich verringerten Zeitaufwand bzw. apparativen Aufwand. Durch den relativ hohen Druck in der Kammer der Plasmaanlage sind im Übrigen nun auch Werkstücke aus beispielsweise stark ausgasenden Sintermaterialien bearbeitbar.

Weiter ist vorteilhaft, dass durch die angelegte Substratelektrodenspannung und den gewählten Druck in der Plasmaanlage die reaktiven Eigenschaften des HF-ICP-Plasmas zur Erzeugung einer Beschichtung und/oder zur Erzielung einer Oberflächenmodifikation auf dem Substrat verbessert werden.

Insgesamt ist das erfindungsgemäße Verfahren ein Hochraten-Abscheideverfahren, das im Grobvakuum bei geringen Prozesszeiten bzw. Pumpzeiten durchführbar ist, und das zur Abscheidung bzw. Erzeugung von Beschichtungen auf allen technisch relevanten Substraten, beispielsweise Edelstahl, andere elektrisch leitende Materialien, Keramik usw., geeignet ist.

Vorteilhafte Weiterbildungen der Erfindung ergeben sich aus den in den Unteransprüchen genannten Maßnahmen.

So lässt sich dadurch, dass die Hochfrequenz-Plasmastrahlquelle und die Kammer mit dem Substrat lediglich über die Austrittsöffnung der Plasmastrahlquelle miteinander in Verbindung stehen, in einfacher Weise über eine entsprechende Pumpeinrichtung eine Druckdifferenz zwischen dem Inneren der Plasmastrahlquelle und dem Kammerinneren aufrecht erhalten.

Weiterhin ist vorteilhaft, wenn das Beaufschlagen der Substratelektrode mit einer elektrischen Spannung mit einer zeitlich periodischen Veränderung der Intensität des von der Plasmastrahlquelle erzeugten Plasmastrahls korreliert wird. Auf diese Weise wird einerseits die Temperaturbelastung des Substrates weiter reduziert und andererseits treten durch das Schwanken der Intensität des Plasmastrahles, der bevorzugt periodisch auch gelöscht wird, in dem Plasma in hohem Ausmaß plasmaphysikalische Ungleichgewichtszustände auf, die dazu genutzt werden können, neuartige Beschichtungen auf dem Substrat abzuscheiden. Hinsichtlich der Auswahl der der Plasmastrahlquelle bzw. dem erzeugten Plasmastrahl zugeführten Materialien zur Erzeugung der Funktionsbeschichtung auf dem Substrat besteht weiter eine große Vielzahl von Möglichkeiten, wobei beispielsweise auf die in DE 199 58 474.5 vorgeschlagenen zurückgegriffen werden kann.

Weitere vorteilhafte Weiterbildungen der Erfindung sehen vor, dass zur Kühlung des Substrates eine Kühleinrichtung und/oder eine bewegliche, vorzugsweise in alle Raumrichtungen bewegliche oder drehbare Halterung vorgesehen ist, so dass das Substrat relativ zu den Plasmastrahlen leicht orientierbar ist und bei der Plasmaabscheidung auf Wunsch auch gekühlt werden kann.

Besonders vorteilhaft ist, wenn die elektrische Spannung, mit der die Substratelektrode beaufschlagt ist, eine zeitlich veränderliche elektrische Spannung, insbesondere eine gepulste elektrische Spannung ist. Diese kann weiter mit einer einstellbaren positiven oder negativen Offset-Spannung versehen sein und/oder mit einem weitgehend frei wählbaren Puls-Pause-Verhältnis gepulst werden. Ein weiterer, einfach zu verändernder und an die Erfordernisse des Einzelfalls anpassbarer Parameter ist daneben die Form der Einhüllenden der zeitlich veränderlichen elektrischen Spannung, die beispielsweise einen sägezahnförmigen, dreiecksförmigen oder sinusförmigen Verlauf aufweisen kann. Im Übrigen kann die eingesetzte elektrische Spannung auch eine Gleichspannung sein.

Weitere, leicht zu verändernde Parameter hinsichtlich der konkreten Signalform der eingesetzten elektrischen Spannung sind ihre Flankensteilheit, ihre Amplitude und ihre Frequenz. Daneben sei betont, dass die zeitliche Veränderung der in die Substratelektrode eingekoppelten Spannung nicht notwendig periodisch sein muss.

### Zeichnungen

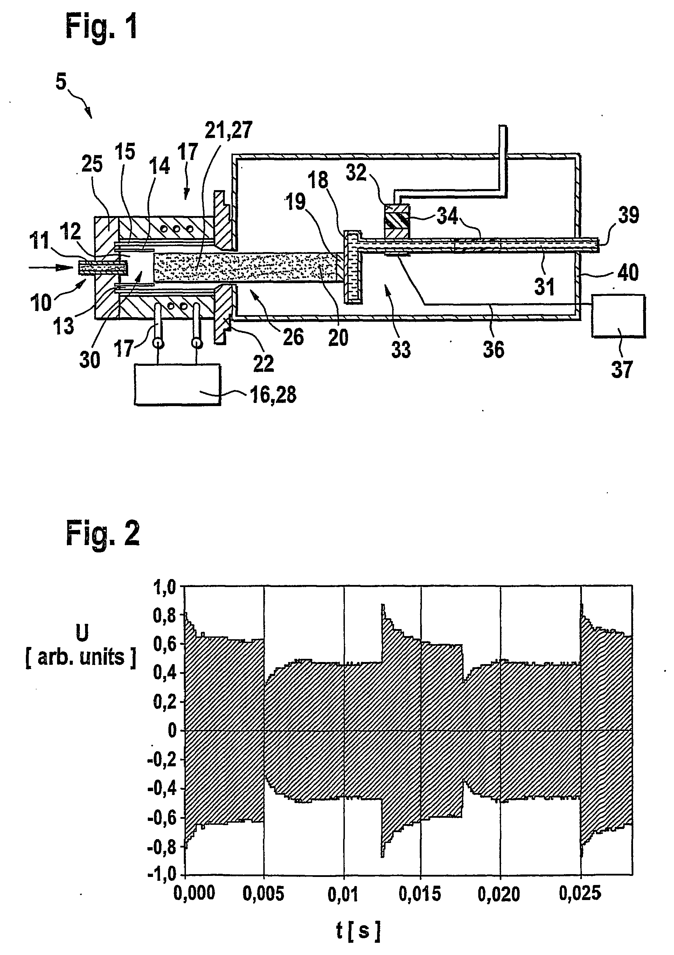

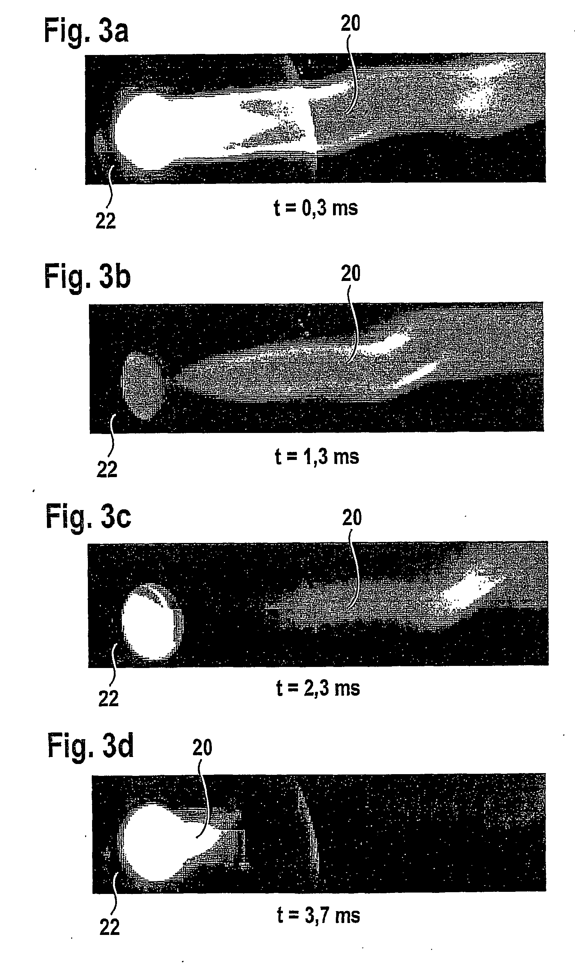

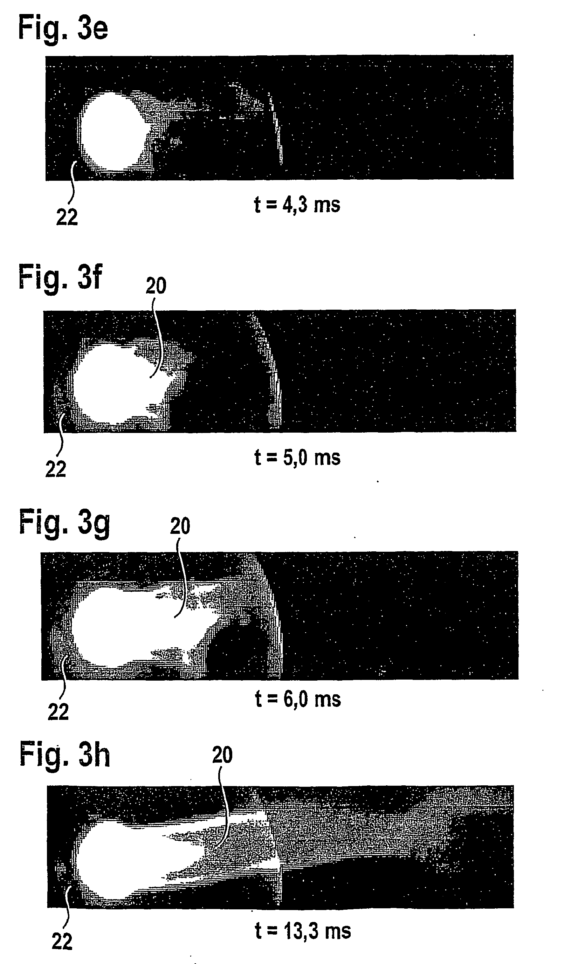

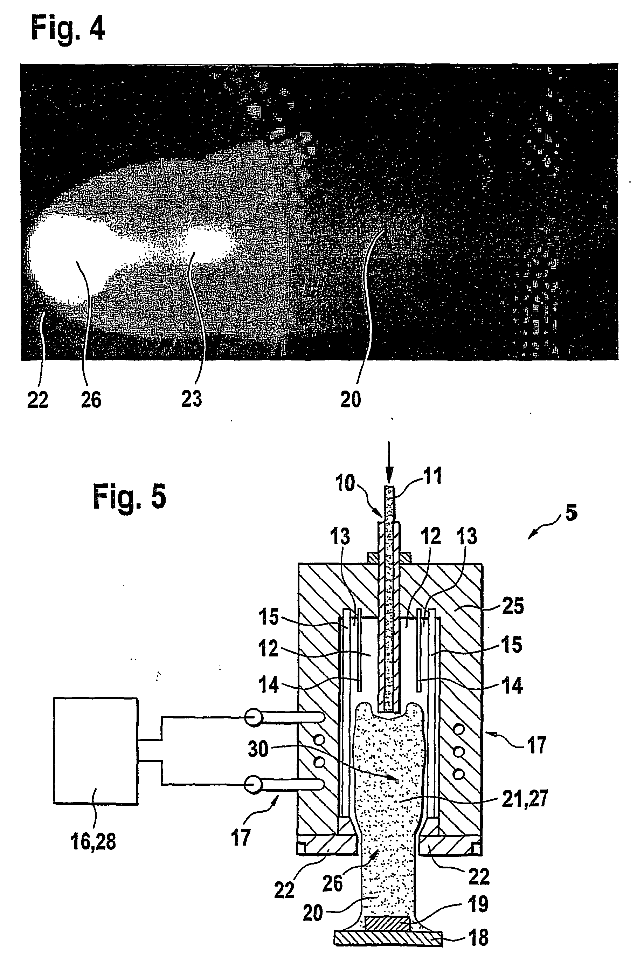

Die Erfindung wird anhand der Zeichnungen und in der nachfolgenden Beschreibung näher erläutert. Es zeigt Figur 1 ein erstes Ausführungsbeispiel einer erfindungsgemäßen Plasma anlage mit einer ICP-Plasmastrahlquelle im Schnitt und Figur 2 ein Beispiel für eine zeitliche Variation der Intensität des erzeugten Plasmastrahles. Die Figuren 3a bis 3h zeigen Aufnahmen des aus der Plasmastrahlquelle austretenden Plasmastrahles als Funktion der Zeit, der gemäß Figur 2 gepulst ist. Die Figur 4 zeigt eine Aufnahme eines Plasmastrahls, der mit hoher Geschwindigkeit aus der Plasmastrahlquelle austritt. Die Figur 5 erläutert die Plasmastrahlquelle gemäß Figur 1 im Detail.

### Ausführungsbeispiele

Die Erfindung geht aus von einer induktiv gekoppelten Hochfrequenz-Plasmastrahlquelle, wie sie in ähnlicher Form aus E. Pfender und C. H. Chang "Plasma Spray Jets and Plasma Particulate Interaction: Modelling and Experiments", Tagungsband des 6. Workshop Plasmatechnik, TU Illmenau, 1998, bekannt ist. Weiter wird damit ein Beschichtungsverfahren durchgeführt, das in ähnlicher Form in DE 199 58 474.5 bereits vorgeschlagen worden ist.

Im Einzelnen zeigt Figur 1 eine induktiv gekoppelte Hochfrequenz-Plasmastrahlquelle 5 mit einem topfförmigen Brennerkörper 25, der einseitig eine mit einer bevorzugt variabel einstellbaren bzw. geformten Öffnungsblende 22 versehene Austrittsöffnung 26 aufweist, die beispielsweise kreisförmig mit einem Durchmesser von 1 cm bis 10 cm ausgebildet ist. Weiter weist die Plasmastrahlquelle 5 eine im Bereich der Austrittsöffnung 26 in den Brennerkörper 25 integrierte Spule 17, beispielsweise eine wassergekühlte Kupferspule, auf, die alternativ auch um den Brennerkörper 25 herumgewickelt sein kann.

Weiter ist auf der der Austrittsöffnung 26 abgewandten Seite des Brennerkörpers 25 eine Zuführung 10 in Form eines üblichen Injektors zur Zufuhr eines Injektorgases 11, eine erste zylinderförmige Hülse 14 und eine zweite zylinderförmige Hülse 15 vorgesehen. Die erste Hülse 14 bzw. die zweite Hülse 15 sind jeweils konzentrisch zu der Seitenwand des Brennerkörpers 25 ausgebildet, wobei die zweite Hülse 15 in erster Linie dazu dient, ein in dem Brennerkörper 25 in einem Plasmaerzeugungsraum 27 erzeugtes Plasma 21 von den Wänden des Brennerkörpers 25 abzuhalten.

Dazu wird über eine geeignete Gaszufuhr ein Hüllgas 13 zwischen der ersten Hülse 14 und der zweiten Hülse 15 in den Brennerkörper 25 eingeleitet, das weiter die Aufgabe hat, das erzeugte Plasma 21 über die Austrittsöffnung 26 strahlförmig aus der Plasmastrahlquelle 5 heraus zu blasen, so dass ein Plasmastrahl 20 entsteht, der weitgehend gebündelt auf ein in einer Kammer 40 auf einem Substratträger 18, der im konkreten Beispiel gleichzeitig als Substratelektrode 18 dient, befindliches Substrat 19 einwirkt, um dort eine Funktionsbeschichtung zu erzeugen und/oder abzuscheiden.

Das Hüllgas 13 ist im erläuterten Beispiel Argon, das der Plasmastrahlquelle 5 mit einem Gasfluss von 5000 sccm bis 100000 sccm, insbesondere 20000 sccm bis 70000 sccm, zugeführt wird.

In Figur 1 ist weiter vorgesehen, dass die Spule 17 mit einem Hochfrequenz-Generator 16 elektrisch verbunden ist, mit dem eine elektrische Leistung von 500 W bis 50 kW, insbesondere 1 kW bis 10 kW, bei einer Hochfrequenz von 0,5 MHz bis 20 MHz in die Spule 17 und darüber auch in das in dem Plasmaerzeugungsraum 27 gezündete und aufrecht erhaltene Plasma 21 eingekoppelt wird.

Der Hochfrequenz-Generator 16 ist in bevorzugter Ausgestaltung mit einem an sich bekannten elektrischen Bauteil 28 versehen, mit dem die Intensität des Plasmastrahls 20 bei dessen Einwirken auf das Substrat 19 zeitlich periodisch mit einer Frequenz von 1 Hz bis 10 kHz, insbesondere 50 Hz bis 1 kHz, zwischen einer einstellbaren oberen und einer einstellbaren unteren Intensitätsgrenze verändert werden kann. Bevorzugt wird der Plasmastrahl 20 dabei über eine einstellbare Zeitdauer, d.h. ein wählbares Puls-Pause-Verhältnis, periodisch auch gelöscht.

Die Figur 1 zeigt weiter, dass über die erste Hülse 14 dem Bereich zwischen der ersten Hülse 14 und der Zuführung 10 ein Zentralgas 12 zugeführt werden kann. Dieses ist beispielsweise ein Inertgas oder ein Inertgas, dem ein mit dem Injektorgas 11 reagierendes Gas zugesetzt ist.

Insbesondere ist vorgesehen, dass über die Zuführung 10 bzw. eine zwischen erster Hülse 14 und Zuführung 10 befindliche weitere Zufuhreinrichtung dem Plasma 20 ein gasförmiges, mikroskaliges oder nanoskaliges Precursor-Material, eine Suspension eines solchen Precursor-Materials oder ein Reaktivgas zugeführt wird, das in modifizierter Form, insbesondere nach Durchlaufen einer chemischen Reaktion oder einer chemischen Aktivierung, auf dem Substrat 19 die gewünschte Funktionsbeschichtung ausbildet oder dort in diese integriert wird.

Alternativ kann das Plasma 21 jedoch auch dazu eingesetzt werden, die Oberfläche des Substrates 19 lediglich chemisch zu modifizieren, so dass dadurch auf der Oberfläche des Substrates 19 die gewünschte Funktionsbeschichtung entsteht.

Sofern ein Precursor-Material dem Plasma 21 bzw. dem Plasmastrahl 20 zugeführt wird, wird bevorzugt gleichzeitig ein Trägergas für dieses Precursor-Material, insbesondere Stickstoff und/oder ein Reaktivgas für eine chemische Reaktion mit dem Precursor-Material, insbesondere Sauerstoff, Stickstoff, Ammoniak, ein Silan, Acetylen, Methan oder Wasserstoff zugeführt. Zur Zufuhr dieser Gase eignen sich entweder die Zuführung 10, die Zufuhreinrichtung zur Zufuhr des Zentralgases 12 oder auch die Zufuhreinrichtung zur Zufuhr des Hüllgases 13. Alternativ oder zusätzlich kann weiter in der Kammer 40 auch eine weitere Zufuhreinrichtung, beispielsweise ein Injektor oder eine Gasdusche, zur Zufuhr eines Reaktivgases und/oder eines Precursor-Materials in den bereits aus der Plasmastrahlquelle 5 ausgetretenen Plasmastrahl 20 vorgesehen sein.

Das eingesetzte Precursor-Material ist bevorzugt eine organische, eine siliziumorganische oder eine metallorganische Verbindung, die somit dem Plasma 21 und/oder dem Plasmastrahl 20 in gasförmiger oder flüssiger Form, als mikroskalige oder nanoskalige Pulverpartikel, als flüssige Suspension, insbesondere mit darin suspendierten mikroskaligen oder nanoskaligen Partikeln, oder als Mischung von gasförmigen oder flüssigen Stoffen mit Feststoffen zugeführt werden kann. Durch geeignete Auswahl der einzelnen Gase, d.h. der zugeführten Reaktivgase bzw. des Zentralgases 12 und des Injektorgases 11 sowie Auswahl des Precursor-Materials, was im Einzelnen in DE 199 58 474.5 erläutert ist, kann auf dem Substrat 19 beispielsweise ein Metallsilizid, ein Metallcarbid, ein Siliziumcarbid, ein Metalloxid, ein Siliziumoxid, ein Metallnitrid, ein Siliziumnitrid, ein Metallborid, ein Metallsulfid, amorpher Kohlenstoff, diamantähnlicher Kohlenstoff (DLC), oder auch eine Mischung aus diesen Materialien in Form einer Schicht oder einer Abfolge Schichten erzeugt bzw. abgeschieden werden. Weiter eignet sich das vorgeschlagene Verfahren auch zur Reinigung oder Carbonisierung oder Nitrierung der Oberfläche des Substrates 19.

Die Figur 1 zeigt weiter dargestellt, dass die Substratelektrode 18 über eine Kühlwasserzufuhr 31 mit Kühlwasser 39 kühlbar ist, und dass die Substratelektrode 18 und damit auch das Substrat 19 über eine entsprechende Halterung 32 in der Kammer 40 bewegbar ist. Dabei ist sowohl die Halterung 32 als auch die Kühlwasserzufuhr 31 elektrisch über eine Isolierung 34 von der mit der elektrischen Spannung beaufschlagten Substratelektrode 18 getrennt. Bevorzugt ist das Substrat 19 mit der Substratelektrode 18 auf einer beweglichen, insbesondere in alle Raumrichtungen beweglichen und/oder drehbaren Halterung 32 angeordnet.

Weiter ist vorgesehen, dass die Substratelektrode 18 mit einem Substratgenerator 37 elektrisch in Verbindung steht, mit dem eine elektrische Spannung in die Substratelektrode 18 und darüber auch in das Substrat 19 eingekoppelt wird. Dazu ist eine Generatorzuleitung 36 zwischen Substratgenerator 37 und Substratelektrode 18 vorgesehen.

Im Einzelnen wird die Substratelektrode 18 mit dem Substratgenerator 37 mit einer elektrischen Gleichspannung oder einer Wechselspannung einer Amplitude zwischen 10 V und 5 kV, insbesondere zwischen 50 V und 300 V, und einer Frequenz zwischen 0 Hz und 50 MHz, insbesondere zwischen 1 kHz und 100 kHz, beaufschlagt. Diese Gleichspannung bzw. Wechselspannung kann zusätzlich auch zeitweise bzw. fortwährend mit einer positiven oder negativen Offset-Spannung versehen sein.

Bevorzugt ist die eingekoppelte elektrische Spannung eine zeitlich veränderliche elektrische Spannung, insbesondere eine gepulste elektrische Spannung mit einem im Einzelfall anhand einfacher Vorversuche auszuwählenden Puls-Pause-Verhältnis sowie einer gegebenenfalls ebenfalls zeitlich, beispielsweise hinsichtlich des Vorzeichens, variierenden Offset-Spannung.

Bevorzugt wird die zeitliche Variation der elektrischen Spannung so eingestellt, dass deren Einhüllende einen unipolaren oder bipolaren sägezahnförmigen, dreiecksförmigen oder sinusförmigen Verlauf aufweist. Weitere Parameter sind dabei die Amplitude und Polarität der Offset-Spannung, die Flankensteilheit der einzelnen Pulse der eingekoppelten elektrischen Spannung, die Frequenz (Trägerfrequenz) dieser Spannung sowie deren Amplitude.

Eine besonders bevorzugte Ausgestaltung des erfindungsgemäßen Verfahrens sieht vor, dass die Veränderung der Intensität des Plasmastrahles 20 über den Hochfrequenz-Generator 16 und das darin integrierte elektrische Bauteil 28, das im Übrigen auch als separates elektrisches Bauteil ausgeführt und dann zwischen Spule 17 und Hochfrequenz-Generator 16 geschaltet werden kann, insbesondere das Pulsen des Plasmastrahls 20, zeitlich korreliert zu der Veränderung oder dem Pulsen der in die Substratelektrode 18 eingekoppelten elektrischen Spannung erfolgt.

Diese zeitliche Korrelation ist weiter bevorzugt ein gegenphasiges oder zeitlich versetztes Pulsen der Intensität des Plasmastrahls 20 gegenüber der Veränderung oder dem Pulsen der elektrischen Spannung.

In Figur 1 ist im Übrigen angedeutet, dass im Inneren der Plasmastrahlquelle 5 ein erster Druckbereich 30 vorliegt, in dem ein Druck von 1 mbar bis 2 bar, insbesondere 100 mbar bis 1 bar, herrscht. Im Inneren der Kammer 40 liegt dann ein zweiter Druckbereich 33 vor.

Um die Druckdifferenz zwischen dem ersten und dem zweiten Druckbereich 30, 33 aufrechtzuerhalten und insbesondere den Druck in der Kammer 40 unter 50 mbar, insbesondere zwischen 1 mbar bis 10 mbar, zu halten, sind daneben übliche, nicht dargestellte Pumpeinrichtungen mit der Kammer 40 verbunden. Somit wird liegt stets ein Druckgradient zwischen dem Inneren der Plasmastrahlquelle 5 und dem Inneren der Kammer 40 vor, obwohl der Plasmastrahlquelle 5 bei Betrieb permanent wie erläutert Gas zugeführt wird und die Plasmastrahlquelle 5 und Kammer 40 über die Austrittsöffnung 26 miteinander verbunden sind.

Bevorzugt sind die Drücke so gewählt, dass das Verhältnis des Druckes in dem ersten Druckbereich 30 zu dem Druck in dem zweiten Druckbereich 33 größer als 1,5, insbesondere größer 3, ist.

Beispielsweise wird über eine mit der Kammer 40 verbundene, nicht dargestellte Pumpeinrichtung eine Druckdifferenz von mehr als 100 mbar zwischen dem Plasmaerzeugungsraum 27 im Innern der Plasmastrahlquelle 5 und dem Inneren der Kammer 40 aufrechterhalten.

Als Material für das Substrat 19 eignen sich bei der Durchführung des erfindungsgemäßen Verfahrens sowohl elektrisch leitende als auch, bei geeigneter Wahl der zeitlich veränderlichen Spannung an der Substratelektrode, elektrisch isolierende Materialien. Daneben führt die durch die Kühleinrichtung und insbesondere das Pulsen des Plasmastrahls 20 gegebene Verringerung der Temperaturbelastung des Substrates 19 dazu, dass auch temperaturempfindlichen Substrate wie beispielsweise Polymere einsetzbar sind.

Die Figur 2 erläutert, wie der Plasmastrahl 20 durch zeitliche Veränderung der von dem Hochfrequenz-Generator 16 im Zusammenwirken mit dem elektrischen Bauteil 28 durch eine zeitliche Veränderung der der Spule 17 zugeführten Spannung entsprechend der Veränderung dieser Spannung in seiner Intensität verändert wird. Insbesondere kann die Spannung in Weiterführung von Figur 2 an der Spule 17 zeitweilig auch 0 sein, so dass der Plasmastrahl 20 in dieser Zeit erlischt.

Die Figuren 3a bis 3h zeigen direkt den aus der Austrittsöffnung 26 über die Öffnungsblende 22 austretenden Plasmastrahl 20 in der Kammer 40. Der typische Abstand zwischen Austrittsöffnung 26 und Substrat 19 liegt bei 5 cm bis 50 cm.

Man erkennt in den Figuren 3a bis 3h, wie der Plasmastrahl 20 zunächst gemäß Figur 3a zur Zeit t = 0 mit hoher Intensität aus der Austrittsöffnung 26 austritt, sich diese Intensität gemäß Figur 3b dann deutlich vermindert, so dass der Plasmastrahl 20 kurz danach vollständig erlischt, anschließend der Plasmastrahl gemäß den Figuren 3c bis 3e neu gezündet wird und dabei kurz zurückschwingt, bevor er sich dann gemäß den Figuren 3f bis 3h kontinuierlich ausdehnt, so dass nach 13,3 ms der Ausgangszustand gemäß Figur 3a nahezu wieder erreicht ist. Dieses Pulsen des Plasmastrahls 20 gemäß den Figuren 3a bis 3h wird durch eine Veränderung der in die Spule 17 eingekoppelten elektrischen Hochfrequenzleistung bewirkt.

Die Figur 4 erläutert, wie der Plasmastrahl 20 durch eine entsprechend hohe Druckdifferenz zwischen dem Inneren der Plasmastrahlquelle 5 und dem Inneren der Kammer 40, d.h. dem erläuterten Druckgradienten hin zur Kammer 40, der Plasmastrahl 20 mit hoher Geschwindigkeit aus der Austrittsöffnung 26 austritt und mit entsprechend hoher Geschwindigkeit auf das Substrat 19 einwirkt. Insbesondere ist in Figur 4 Verdichtungsknoten 23 (Mach'sche Knoten) erkennbar, die belegen, dass die Geschwindigkeit der Teilchen im Plasmastrahl 20 in gleicher Größenordnung wie die Schallgeschwindigkeit liegt. Sie kann im Übrigen auch größer als diese sein.

Durch die hohe Geschwindigkeit des Plasmastrahls 20, die über die Druckdifferenz beeinflussbar ist, wird erreicht, dass nicht nur tiefe Hohlräume auf der Oberfläche des Substrates 19 mit dem Plasma 21 beaufschlagt werden, sondern dass auch die Diffusionsgrenzschicht zwischen der Oberfläche des Substrates 19 und dem Plasmastrahl 20 verkleinert wird, was die Diffusion reaktiver Plasmabestandteile auf die Oberfläche des Substrates 19 erleichtert und so die erforderliche Bearbeitungsdauer des Substrates 19 mit dem Plasmastrahl 20 verkürzt bzw. intensiviert.

Die Figur 5 erläutert einen Ausschnitt aus Figur 1, wobei die Plasmastrahlquelle 5 noch einmal vergrößert dargestellt ist. Dabei ist insbesondere die Anordnung der Zuführung 10 und die Ausgestaltung der ersten Hülse 14 und der zweiten Hülse 15 deutlicher erkennbar.

## Patentansprüche

1. Plasmaanlage mit mindestens einer induktiv gekoppelten Hochfrequenz-Plasmastrahlquelle (5) mit einem einen Plasmaerzeugungsraum (27) begrenzenden Brennerkörper (25) mit einer Austrittsöffnung für den Plasmastrahl (20) sowie einer mit der Plasmastrahlquelle (5) über die Austrittsöffnung (26) in Verbindung stehenden Kammer (40) mit einem darin angeordneten, dem Plasmastrahl (20) ausgesetzten Substrat (19), wobei das Substrat (19) auf einer mit einer elektrischen Spannung beaufschlagbaren Substratelektrode (18) angeordnet ist, **dadurch gekennzeichnet, dass** eine Zuführung (10) in der Plasmastrahlquelle (5) und/oder eine Zufuhreinrichtung in der Kammer (40) vorgesehen ist, mit der dem Plasma (21) oder dem Plasmastrahl (20) mindestens ein insbesondere gasförmiges oder mikroskaliges oder nanoskaliges Precursor-Material, eine Suspension eines solchen Precursor-Materials oder ein Reaktivgas zuführbar ist, das in modifizierter Form, insbesondere nach Durchlaufen einer chemischen Reaktion oder einer chemischen Aktivierung, auf dem Substrat (19) eine Funktionsbeschichtung ausbildet oder in diese integriert wird und dass der Brennerkörper (25) topfförmig ausgebildet ist und die Spule (17) den Brennerkörper (25) in einer Umgebung der Austrittsöffnung (26) umgibt oder dort in diesen integriert ist, dass zusätzlich zur ersten Zuführung (10) zur Zufuhr eines Injektorgases (11) in den Plasmaerzeugungsraum (27), insbesondere eines Precursor-Materials zur Erzeugung einer Funktionsbeschichtung auf einem Substrat (19) mit dem Plasmastrahl (20), mindestens eine zweite Zuführung zur Zufuhr eines mit dem Injektorgas (11) reagierenden Zentralgases (12) in den Plasmaerzeugungsraum (27) und/oder eines den Brennerkörper (25) von dem darin erzeugten Plasma (21) zumindest bereichsweise trennenden, insbesondere das Plasma (21) konzentrisch umgebenden Hüllgases (13) in den Plasmaerzeugungsraum (27) vorgesehen ist.

2. Plasmaanlage nach Anspruch 1, **dadurch gekennzeichnet, dass** die Substratelektrode (18) mit einem Generator (37) verbunde ist, mit dem die Substratelektrode (18) mit einer elektrischen Gleichspannung oder Wechselspannung einer Amplitude zwischen 10 Volt und 5 kV, insbesondere zwischen 50 Volt und 300 Volt, und einer Frequenz zwischen 0 Hz und 50 MHz, insbesondere zwischen 1 kHz und 100 kHz, beaufschlagbar ist.

3. Plasmaanlage nach Anspruch 1 oder 2, **dadurch gekennzeichnet, dass** der Brennerkörper (25) eine den Plasmaerzeugungsraum (27) bereichsweise umgebende Spule (17) und einen mit der Spule (17) in Verbindung stehenden Hochfrequenzgenerator (16) zur Zündung des Plasmas (21) und Einkoppelung einer elektrischen Leistung in das Plasma (21) aufweist.

4. Plasmaanlage nach Anspruch 1 oder 3, **dadurch gekennzeichnet, dass** ein Mittel (28) vorgesehen ist, mit dem die Intensität des Plasmastrahles (20) der Plasmastrahlquelle (5) zeitlich periodisch veränderbar ist.

5. Plasmaanlage nach einem der vorangehenden Ansprüche, **dadurch gekennzeichnet, dass** die Kammer (40) mit einer Pumpeinrichtung verbunden ist, mit der bei Betrieb der Plasmaanalage eine Druckdifferenz von mehr als 100 mbar zwischen Plasmaerzeugungsraum (27) und Kammerinnerem aufrecht erhaltbar ist und/oder dass das Verhältnis des Druckes in dem Plasmaerzeugungsraum (27) zu dem Druck in dem Inneren der Kammer (40) größer als 1,5, insbesondere größer 3, ist.

6. Verfahren zur Erzeugung einer Funktionsbeschichtung auf einem in einer Kammer (40) angeordneten Substrat (19), wobei mittels einer induktiv gekoppelten Hochfrequenz-Plasmastrahlquelle (5) ein Plasma (21) mit reaktiven Teilchen erzeugt wird, das in Form eines Plasmastrahles (20) aus der Plasmastrahlquelle (5) in die damit verbundene Kammer (40) eintritt und auf das Substrat (19) derart einwirkt, dass auf dem Substrat (19) eine Funktionsbeschichtung erzeugt oder abgeschieden wird, wobei das Substrat (19) auf einer Substratelektrode (18) angeordnet und darüber zumindest zeitweise mit einer elektrischen Spannung beaufschlagt wird, **dadurch gekennzeichnet, dass** dem Plasma (21) über eine Zuführung (10) in der Plasmastrahlquelle (5) und/oder dem Plasmastrahl (20) über eine Zufuhreinrichtung in der Kammer (40) mindestens ein insbesondere gasförmiges oder mikroskaliges oder nanoskaliges Precursor-Material, eine Suspension eines solchen Precursor-Materials oder ein Reaktivgas zugeführt wird, das in modifizierter Form, insbesondere nach Durchlaufen einer chemischen Reaktion oder einer chemischen Aktivierung, auf dem Substrat (19) die Funktionsbeschichtung ausbildet oder in diese integriert wird und dass die elektrische Spannung zeitlich verändert, insbesondere zumindest zeitweise mit einer einstellbaren Offset-Spannung versehen und/oder mit einem wählbaren Puls-Pause-Verhältnis gepulst wird.

7. Verfahren nach Anspruch 6, **dadurch gekennzeichnet, dass** eine Gleichspannung oder Wechselspannung einer Amplitude zwischen 10 Volt und 5 kV, insbesondere zwischen 50 Volt und 300 Volt, und einer Frequenz zwischen 0 Hz und 50 MHz, insbesondere zwischen 1 kHz und 100 kHz, über einen Generator (37) in die Substratelektrode (18) eingekoppelt wird.

8. Verfahren nach Anspruch 6, **dadurch gekennzeichnet, dass** die Einhüllende der zeitlich veränderten Spannung einen unipolaren oder bipolaren sägezahnförmigen, dreiecksförmigen oder sinusförmigen Verlauf aufweiset.

9. Verfahren nach einem der Ansprüche 6 bis 8, **dadurch gekennzeichnet, dass** die Intensität des Plasmastrahls (20) bei dem Einwirken auf das Substrat (19) zeitlich periodisch mit einer Frequenz von 1 Hz bis 10 kHz, insbesondere 50 Hz bis 1 kHz, zwischen einer einstellbaren oberen und einer einstellbaren unteren Grenze verändert und insbesondere der Plasmastrahl (20) über eine einstellbare Zeitdauer periodisch auch gelöscht wird.

10. Verfahren nach einem der Ansprüche 6 bis 9, **dadurch gekennzeichnet, dass** in der Hochfrequenz-Plasmastrahlquelle (5) über eine Spule (17) eine elektrische Leistung von 500 Watt bis 50 kW, insbesondere 1 kW bis 10 kW, bei einer Hochfrequenz von 0,5 MHz bis 20 MHz in das Plasma (21) eingekoppelt wird.

11. Verfahren nach einem der Ansprüche 6 bis 10, **dadurch gekennzeichnet, dass** das Plasma (21) mittels Zufuhr eines Gases, insbesondere Argon, mit einem Gasfluss von 5000 sccm bis 100000 sccm, insbesondere 20000 sccm bis 70000 sccm, zu der Plasmastrahlquelle (5) über eine Austrittsöffnung (26) strahlförmig aus der Plasmastrahlquelle (5) herausgeblasen und in die Kammer (40) geführt wird.

12. Verfahren nach einem der Ansprüche 6 bis 11, **dadurch gekennzeichnet, dass** dem Plasma (21) ein Trägergas für das Precursor-Material, insbesondere Stickstoff, und/oder ein Reaktivgas für eine chemische Reaktion mit dem Precursor-Material, insbesondere Sauerstoff, Stickstoff, Ammoniak, Silan, Acetylen, Methan oder Wasserstoff, zugeführt wird.

13. Verfahren nach einem der Ansprüche 6 bis 12, **dadurch gekennzeichnet, dass** das Precursor-Material eine organische, eine siliziumorganische oder eine metallorganische Verbindung ist, die dem Plasma (21) und/oder dem Plasmastrahl (20) in gasförmiger oder flüssiger Form, als mikro- oder nanoskalige Pulverpartikel, als flüssige Suspension, insbesondere mit darin suspendierten mikro- oder nanoskaligen Partikeln, oder als Mischung von gasfömigen oder flüssigen Stoffen mit Feststoffen zugeführt wird.

14. Verfahren nach einem der Ansprüche 6 bis 13, **dadurch gekennzeichnet, dass** die Plasmastrahlquelle (5) bei einem Druck von 1 mbar bis 2 bar, insbesondere 100 mbar bis 1 bar, betrieben wird und dass der Druck in der Kammer unter 50 mbar, insbesondere zwischen 1 mbar bis 10 mbar, gehalten wird.

15. Verfahren nach einem der Ansprüche 6 bis 14, **dadurch gekennzeichnet, dass** die Veränderung der Intensität des Plasmastrahles (21), insbesondere das Pulsen des Plasmastrahls (21) zeitlich korreliert, insbesondere gegenphasig oder zeitlich versetzt zu der Veränderung oder dem Pulsen der elektrischen Spannung erfolgt.

## Claims

1. Plasma installation having at least one inductively coupled radio-frequency plasma beam source (5) having a burner body (25) which bounds a plasma production area (27) and has an outlet opening for the plasma beam (20), as well as a chamber (40) which is connected to the plasma beam source (5) via the outlet opening (26) and has a substrate (19) which is arranged therein and is subject to the plasma beam (20), wherein the substrate (19) is arranged on a substrate electrode (18) to which an electrical voltage can be applied, **characterized in that** a supply (10) is provided in the plasma beam source (5), and/or a supply device is provided in the chamber (40) by means of which at least one precursor material, which in particular is gaseous or is on a microscale or a nanoscale, a suspension of such a precursor material or a reactive gas can be supplied to the plasma (21) or to the plasma beam (20) which material or gas forms a functional coating on the substrate (19) in a modified form, in particular after passing through a chemical reaction or chemical activation, or is integrated in said functional coating, and **in that** the burner body (25) is in the form of a pot and the coil (17) surrounds the burner body (25) in the vicinity of the outlet opening (26), or is integrated therein there, **in that**, in addition to the first supply (10), and in order to supply an injector gas (11) into the plasma production area (27), in particular a precursor material for production of a functional coating on a substrate (19) by means of the plasma beam (20), at least one second supply is provided for supplying a central gas (12) which reacts with the injector gas (11), into the plasma production area (27), and/or for supplying an enveloping gas (13) into the plasma production area (27), which enveloping gas (13) separates the burner body (25) from the plasma (21) that is produced therein, at least in places, and in particular concentrically surrounds the plasma (21).

2. Plasma installation according to Claim 1, **characterized in that** the substrate electrode (18) is connected to a generator (37) by means of which the substrate electrode (18) can be supplied with an electrical DC voltage or AC voltage with an amplitude of between 10 volts and 5 kV, in particular between 50 volts and 300 volts, and at a frequency of between 0 Hz and 50 MHz, in particular between 1 kHz and 100 kHz.

3. Plasma installation according to Claim 1 or 2, **characterized in that** the burner body (25) has a coil (17) which surrounds the plasma production area (27) in places, and has a radio-frequency generator (16), which is connected to the coil (17), in order to ignite the plasma (21) and to inject electrical power into the plasma (21).

4. Plasma installation according to Claim 1 or 3, **characterized in that** a means (28) is provided, by means of which the intensity of the plasma beam (20) from the plasma beam source (5) can be varied periodically in time.

5. Plasma installation according to one of the preceding claims, **characterized in that** the chamber (40) is connected to a pump device, by means of which a pressure difference of more than 100 mbar can be maintained during operation of the plasma installation between the plasma production area (27) and the chamber interior, and/or **in that** the ratio of the pressure in the plasma production area (27) to the pressure in the interior of the chamber (40) is greater than 1.5, in particular greater than 3.

6. Method for production of a functional coating on a substrate (19) which is arranged in a chamber (40), wherein a plasma (21) is produced with reactive particles by means of an inductively coupled radio-frequency plasma beam source (5), which plasma (21) is in the form of a plasma beam (20) originating from the plasma beam source (5) and enters the chamber (40) connected thereto, and acts on the substrate (19) such that a functional coating is produced or deposited on the substrate (19), wherein the substrate (19) is arranged on a substrate electrode (18) and, via this, has an electrical voltage applied to it at least at times, **characterized in that** at least one in particular gaseous or microscale or nanoscale precursor material, a suspension of such a precursor material or a reactive gas is supplied to the plasma (21) via a supply (10) in the plasma beam source (5) and/or to the plasma beam (20) via a supply device in the chamber (40), which material or gas forms the functional coating on the substrate (19) in modified form, in particular after passing through a chemical reaction or chemical activation, or is integrated therein, and **in that** the electrical voltage is varied over time, in particular is provided with an adjustable offset voltage at least at times, and/or is pulsed with a selectable duty ratio.

7. Method according to Claim 6, **characterized in that** a DC voltage or AC voltage with an amplitude of between 10 volts and 5 kV, in particular between 50 volts and 300 volts, and at a frequency of between 0 Hz and 50 MHz, in particular between 1 kHz and 100 kHz, is fed into the substrate electrode (18) via a generator (37).

8. Method according to Claim 6, **characterized in that** the envelope of the voltage which varies over time has a unipolar or bipolar profile, which is in the form of a sawtooth, is triangular or is sinusoidal.

9. Method according to one of Claims 6 to 8, **characterized in that** the intensity of the plasma beam (20) when acting on the substrate (19) is varied periodically over time at a frequency of from 1 Hz to 10 kHz, in particular 50 kHz to 1 kHz, between an adjustable upper limit and an adjustable lower limit, and in particular the plasma beam (20) is also periodically extinguished over an adjustable time period.

10. Method according to one of Claims 6 to 9, **characterized in that** an electrical power of from 500 watts to 50 kW, in particular 1 kW to 10 kW, is fed into the plasma (21) at a radiofrequency of from 0.5 MHz to 20 MHz in the radio-frequency plasma beam source (5), via a coil (17).

11. Method according to one of Claims 6 to 10, **characterized in that** the plasma (21) is blown out of the plasma beam source (5), and is passed into the chamber (40) in the form of a jet, by supplying a gas, in particular argon, at a gas flow rate of from 5000 sccm to 100 000 sccm, in particular 20 000 sccm to 70 000 sccm, to the plasma beam source (5) via an outlet opening (26).

12. Method according to one of Claims 6 to 11, **characterized in that** a carrier gas for the precursor material, in particular nitrogen, and/or a reactive gas for a chemical reaction with the precursor material, in particular oxygen, nitrogen, ammonium, silane, acetylene, methane or hydrogen, is supplied to the plasma (21).

13. Method according to one of Claims 6 to 12, **characterized in that** the precursor material is an organic compound, a silicon-organic compound or a metal-organic compound which is supplied to the plasma (21) and/or to the plasma beam (20) in gaseous or liquid form, as microscale or nanoscale powder particles, as a liquid suspension, in particular with microscale or nanoscale particles suspended therein, or as a mixture of gaseous or liquid substances with solids.

14. Method according to one of Claims 6 to 13, **characterized in that** the plasma beam source (5) is operated at a pressure of from 1 mbar to 2 bar, in particular from 100 mbar to 1 bar, and **in that** the pressure in the chamber is kept below 50 mbar, in particular between 1 mbar and 10 mbar.

15. Method according to one of Claims 6 to 14, **characterized in that** the change in the intensity of the plasma beam (21) in particular the pulsing of the plasma beam (21), is correlated in time, and in particular is carried out in antiphase or with a time offset with respect to the change or the pulsing of the electrical voltage.

## Revendications

1. Système à plasma doté d'une source (5) de faisceau de plasma à haute fréquence couplée inductivement, d'un corps de brûleur (25) qui délimite un espace (27) de formation de plasma, d'une ouverture de sortie du faisceau plasma (20) et d'une deuxième chambre (40) qui communique avec la source (5) de faisceau de plasma par l'ouverture de sortie (26) et dans laquelle est placé un substrat (19) exposé au faisceau de plasma (20),
le substrat (19) étant disposé sur une électrode de substrat (18) sur laquelle une tension électrique peut être appliquée,
**caractérisé en ce que**
au moins un matériau précurseur gazeux à échelle microscopique ou à échelle nanoscopique, une suspension de ce matériau de précurseur ou un gaz réactif qui, sous forme modifiée, et en particulier après avoir subi une réaction chimique ou une activation chimique, forment sur le substrat (19) un revêtement fonctionnel ou sont intégrés dans ce substrat sont apportés dans le plasma (21) par une amenée (10) prévue dans la source (5) de faisceau de plasma et/ou dans le faisceau de plasma (20) par un dispositif d'amenée prévu dans la chambre (40),
**en ce que** le corps de brûleur (25) présente la forme d'une cuvette et la bobine (17) entoure le corps du brûleur (25) au voisinage de l'ouverture de sortie (26) ou est intégrée dans cette dernière et
**en ce qu'**en plus de la première amenée (10) qui amène un gaz d'injecteur (11) dans l'espace (27) de formation de plasma, en particulier un matériau de précurseur, pour former un revêtement fonctionnel sur un substrat (19) à l'aide du faisceau de plasma (20), au moins une deuxième amenée qui amène dans l'espace (27) de formation de plasma un gaz central (12) qui réagit avec le gaz d'injecteur (11) et/ou qui amène dans l'espace (27) de formation de plasma un gaz d'enveloppe (13) qui sépare au moins certaines parties du corps de brûleur (25) du plasma (21) qui y est formé et qui en particulier entoure concentriquement le plasma (21) est prévue.

2. Système de plasma selon la revendication 1, **caractérisé en ce que** l'électrode de substrat (18) est reliée à un générateur (37) qui applique sur l'électrode de substrat (18) une tension électrique continue ou une tension électrique alternative d'une amplitude comprise entre 10 Volt et 5 kV, en particulier entre 50 Volt et 300 Volt, à une fréquence comprise entre 0 Hz et 50 MHz et en particulier entre 1 kHz et 100 kHz.

3. Système de plasma selon les revendications 1 ou 2, **caractérisé en ce que** le corps de brûleur (25) présente une bobine (17) qui entoure certaines parties de l'espace (27) de formation de plasma et un générateur (16) de hautes fréquences relié à la bobine (17) pour allumer le plasma (21) et injecter une puissance électrique dans le plasma (21).

4. Système de plasma selon les revendications 1 ou 3, **caractérisé en ce qu'**il présente un moyen (28) qui permet de modifier périodiquement l'intensité du faisceau de plasma (20) de la source (5) de faisceau de plasma.

5. Système de plasma selon l'une des revendications précédentes, **caractérisé en ce que** la chambre (40) est reliée à un dispositif de pompage qui, lorsque le système de plasma est en fonctionnement, permet de maintenir une différence de pression de plus de 100 mbars entre l'espace (27) de formation de plasma et l'intérieur de la chambre et/ou **en ce que** le rapport entre la pression qui règne dans l'espace (27) de formation de plasma et la pression qui règne à l'intérieur de la chambre (40) est supérieur à 1,5 et en particulier supérieur à 3.

6. Procédé de formation d'un revêtement fonctionnel sur un substrat (19) disposé dans une chambre (40), dans lequel un plasma (21) comportant des particules réactives est formé au moyen d'une source (5) de faisceau de plasma à haute fréquence couplée inductivement, pénètre sous la forme d'un faisceau de plasma (20) provenant de la source (5) de faisceau de plasma dans la chambre (40) qui est reliée à cette dernière et agit sur le substrat (19) de manière à former ou déposer un revêtement fonctionnel sur le substrat (19), le substrat (19) étant disposé sur une électrode de substrat (18) qui y applique une tension électrique pendant au moins une partie du temps,
**caractérisé en ce que**
au moins un matériau précurseur gazeux à échelle microscopique ou à échelle nanoscopique, une suspension de ce matériau de précurseur ou un gaz réactif qui, sous forme modifiée, et en particulier après avoir subi une réaction chimique ou une activation chimique, forment sur le substrat (19) un revêtement fonctionnel ou sont intégrés dans ce substrat sont apportés dans le plasma (21) par une amenée (10) prévue dans la source (5) de faisceau de plasma et/ou dans le faisceau de plasma (20) par un dispositif d'amenée prévu dans la chambre (40),et
**en ce que** la tension électrique est modifiée temporellement, est dotée au moins une partie du temps d'une tension de décalage réglable et/ou est pulsée à un rapport réglable entre les impulsions et les pauses.

7. Procédé selon la revendication 6, **caractérisé en ce qu'**une tension électrique continue ou une tension électrique alternative d'une amplitude comprise entre 10 Volt et 5 kV, en particulier entre 50 Volt et 300 Volt, à une fréquence comprise entre 0 Hz et 50 MHz et en particulier entre 1 kHz et 100 kHz sont appliquées sur l'électrode de substrat (18) par un générateur (37).

8. Procédé selon la revendication 6, **caractérisé en ce que** l'enveloppe de la tension qui varie temporellement présente une évolution unipolaire ou bipolaire en dents de scie, triangulaire ou sinusoïdale.

9. Procédé selon l'une des revendications 6 à 8, **caractérisé en ce que** l'intensité du faisceau de plasma (20) lors de son action sur le substrat (19) varie périodiquement dans le temps à une fréquence de 1 Hz à 10 kHz et en particulier de 50 Hz à 1 kHz entre une limite supérieure réglable et une limite inférieure réglable et **en ce qu'**en particulier le faisceau de plasma (20) est éteint périodiquement pendant une durée réglable.

10. Procédé selon l'une des revendications 6 à 9, **caractérisé en ce que** dans la source (5) de faisceau de plasma à haute fréquence, une puissance électrique de 500 Watt à 50 kW, en particulier de 1 kW à 10 kW, et à une haute fréquence de 0,5 MHz à 20 MHz, est injectée par l'intermédiaire d'une bobine (17) dans le plasma (21).

11. Procédé selon l'une des revendications 6 à 10, **caractérisé en ce que** le plasma (21) est soufflé en faisceau hors de la source (5) de faisceau de plasma, par une ouverture de sortie (26), et est amené dans la chambre (40) au moyen de l'amenée d'un gaz, en particulier de l'argon, dans la source (5) de faisceau de plasma à un débit de gaz de 5 000 cm³ standard par minute (sccm) à 100 000 cm³ standard par minute (sccm) et en particulier de 20 000 cm³ standard par minute (sccm) à 70 000 cm³ standard par minute (sccm).

12. Procédé selon l'une des revendications 6 à 11, **caractérisé en ce qu'**un gaz porteur du matériau de précurseur, en particulier de l'azote, et/ou un gaz réactif qui entre en réaction chimique avec le matériau de précurseur, en particulier de l'oxygène, de l'azote, de l'ammoniac, du silane, de l'acétylène, du méthane ou de l'hydrogène, sont apportés dans le plasma (21).

13. Procédé selon l'une des revendications 6 à 12, **caractérisé en ce que** le matériau de précurseur est un composé organique, un composé organique du silicium ou un composé organométallique qui est amené dans le plasma (21) et/ou dans le faisceau de plasma (20) sous forme gazeuse ou liquide, sous la forme de particules de poudre à échelle microscopique ou à échelle nanoscopique, sous la forme d'une suspension liquide, en particulier dans laquelle des particules microscopiques ou nanoscopiques sont mises en suspension, ou sous la forme d'un mélange de substances gazeuses ou de substances liquides avec des solides.

14. Procédé selon l'une des revendications 6 à 13, **caractérisé en ce que** la source (5) de faisceau de plasma travaille à une pression de 1 mbar à 2 bars et en particulier de 100 mbars à 1 bar et **en ce que** la pression dans la chambre est maintenue en dessous de 50 mbars et en particulier entre 1 mbar et 10 mbars.

15. Procédé selon l'une des revendications 6 à 14, **caractérisé en ce que** la modification de l'intensité du faisceau de plasma (21) et en particulier la pulsation du faisceau de plasma (21) est corrélée temporellement aux modifications ou aux pulsations de la tension électrique, en particulier en opposition de phase ou en décalage temporel.
